# EUROPÄISCHE PATENTANMELDUNG

(11) **EP 2 503 862 A1**
(43) Veröffentlichungstag der Anmeldung: **26.09.2012**
(21) Anmeldenummer: 12002024.3
(22) Anmeldetag: 22.03.2012
(51) Int. Cl.: H05K 3/40, H05K 3/00, H05K 3/42, G06K 19/077

(54) **Substrat mit durchkontaktierten elektrischen leitfähigen Strukturen und Verfahren zu dessen Herstellung**

(30) Priorität: 23.03.2011 DE 102011014820
(71) Anmelder: Giesecke & Devrient GmbH, 81677 München (DE)
(72) Erfinder: Welling, Ando, Dr., 84424 Isen (DE)

(57) **Zusammenfassung**

Bei einem Verfahren zum gegenseitigen Kontaktieren von zwei auf einander gegenüberliegenden Oberflächen (1a, 1b) eines Substrats (1) angeordneten, elektrisch leitfähigen Strukturen (2, 3) durch das Substrat hindurch wird zunächst eine erste elektrisch leitfähige Struktur (3) auf einer ersten Oberfläche (1b) eines flexiblen Substrats (1) aufgebracht. Anschließend wird das flexible Substrat in einem Bereich der ersten elektrisch leitfähigen Struktur (3) in einer Richtung schräg zur ersten Oberfläche (1b) linienförmig durchtrennt, und die beiden an die Durchtrennungslinie (11) angrenzenden Bereiche (20, 30) des flexiblen Substrats (1) werden aneinander vorbeibewegt, bis sie hintereinander verrasten. Schließlich wird auf der gegenüberliegenden Oberfläche (1a) des flexiblen Substrats (1) eine zweite elektrisch leitfähige Struktur (2) so aufgebracht, dass sie mit der ersten elektrisch leitfähigen Struktur (3) in Kontakt kommt und so eine durch das Substrat (1) hindurchführende elektrisch leitende Verbindung herstellt.

## Beschreibung

Die Erfindung betrifft ein Substrat mit elektrisch leitfähigen Strukturen, die auf einander gegenüberliegenden Oberflächen des Substrats angeordnet und durch das Substrat hindurch miteinander kontaktiert sind, sowie ein Verfahren zu dessen Herstellung. Darüber hinaus betrifft die Erfindung ein Wertdokument mit integriertem Schaltkreis, insbesondere eine Chipkarte, das ein solches Substrat aufweist.

Aufgrund der elektrisch leitfähigen Strukturen, die in der Regel als Leiterbahnen ausgebildet sind, können derartige Substrate auch als Leiterplatten bezeichnet werden. Sie werden üblicherweise in IC-Karten (Ausweiskarten, Kreditkarten, Geldkarten oder andere Arten von Chipkarten) als Karteninlett integriert und bilden häufig eine separate Schicht des Kartenkörpers. Auf der einen Seite der Leiterplatte kann sich beispielsweise ein durch die leitfähige Schicht gebildeter integrierter Schaltkreis mit weiteren elektronischen Bauelementen, insbesondere einem Chipmodul, befinden, während die leitfähige Schicht auf der gegenüberliegenden Seite der Leiterplatte beispielsweise als Antennenspule für den kontaktlosen Datenaustausch mit externen Geräten ausgebildet ist, die durch die Leiterplatte hindurch mit dem integrierten Schaltkreis elektrisch leitend verbunden ist. Man spricht in diesem Zusammenhang von einer "Durchkontaktierung" der Leiterplatte. In der Druckschrift WO 02/091811 A2 werden verschiedene Durchkontaktierungsvarianten beschrieben, bei welchen auf das Einbringen einer Metallhülse in ein ausgestanztes oder gebohrtes Durchgangsloch zur elektrischen Verbindung der beiden einander gegenüberliegenden, elektrisch leitfähigen Strukturen verzichtet werden kann. Unter anderem wird dort vorgeschlagen, mittels eines Schnittwerkzeugs, Schneidstempels, Messers oder Lasers eine schnittförmige Durchbrechung durch das Substrat hindurch zu erzeugen und die Durchbrechung anschließend mit einem elektrisch leitfähigen Material zu füllen. Dazu wird mittels einer Dosiernadel ein elektrisch leitfähiger Flüssigkleber oder im Siebdruck Silberleitpaste oder Karbonfarbe oder im Tintenstrahldruck elektrisch leitfähige Tinte auf die Durchgangsöffnung aufgebracht und fließt in die Durchgangsöffnung hinein. Dies geschieht aufgrund des vergleichsweise kleinen Öffnungsquerschnitts der Durchgangsöffnung gegebenenfalls auch unter dem Einfluss von Kapillarkräften. Bei der Erzeugung der Durchbrechung kann die Leiterbahn bereits auf dem Substrat angeordnet sein oder sie wird nach Erzeugung der Durchbrechung auf das Substrat aufgebracht.

Für den Fall, dass die schnittförmige Durchbrechung schräg zur Oberfläche des Substrats erfolgt, kann auf die Verwendung des vorgenannten weiteren leitfähigen Materials zum Füllen der Durchbrechung verzichtet werden. Stattdessen werden die durch den schrägen Schnitt entstehenden Laschen des Substrats aneinander vorbeigedrückt, bis sie hintereinander verrasten, so dass sich die auf dem Substrat gegenüberliegenden Leiterbahnen berühren. Das heißt, in diesem Falle sind die Leiterbahnen bereits vor dem Erzeugen der Durchkontaktierung auf den Oberflächen des Substrats aufgebracht, so dass sich die Leiterbahn auf der Oberseite des Substrats und die Leiterbahn auf der Unterseite des Substrats im Überlappungsbereich der hintereinander verrasteten Laschen berühren.

In der Druckschrift WO 03/043394 A1 sind mechanische Hilfsmittel angegeben, die es ermöglichen, das Durchdrücken der Durchkontaktierungslaschen in einer gemeinsamen Bearbeitungsstation mit dem Schneidwerkzeug zum Erzeugen des schrägen Schnitts zusammenzufassen. Dies kann mittels eines separaten Stößels, mittels Druckluft, durch Anlegen eines Unterdrucks oder durch einen am Schneidwerkzeug fixierten Mitnahmehaken erfolgen.

Der Einbau eines solchen durchkontaktierten Substrats in eine Karte erfolgt üblicherweise durch Laminieren. Dadurch wird die elektrisch leitende Verbindung im Bereich der Durchkontaktierung stabilisiert.

Als nachteilhaft an diese Technologie hat sich herausgestellt, dass sich die Durchkontaktierung nicht ohne weiteres auf elektrische Funktionsfähigkeit überprüfen lässt, da die erzeugten Durchkontaktierungslaschen erst nach Laminierung des in der Regel aus Kunststoff bestehenden Substrats eine zuverlässige elektrische Verbindung eingehen. Vor dem Bestücken der Substrate bzw. Leiterplatten mit hochpreisigen Chips muss die elektrische Funktionsfähigkeit der Durchkontaktierung aber schon zuverlässig, das heißt mit hundertprozentiger Sicherheit, überprüft worden sein. Eine zuverlässige Verbindung muss also bereits vor dem Laminieren sichergestellt sein.

Aufgabe der vorliegenden Erfindung ist es daher, die vorbeschriebene Durchkontaktierungstechnologie dahingehend zu verbessern, dass bereits nach Erzeugen der elektrisch leitfähigen Strukturen auf Vorder- und Rückseite des Substrats und der Durchkontaktierung sicher überprüfbar ist, ob eine elektrisch leitende Verbindung zwischen den beiden elektrisch leitfähigen Strukturen hergestellt ist.

Diese Aufgabe wird durch ein Verfahren und ein mittels des Verfahrens hergestelltes Substrat mit den Merkmalen der unabhängigen Ansprüche gelöst. In davon abhängigen Ansprüchen sind vorteilhafte Weiterbildungen und Ausgestaltungen der Erfindung angegeben.

Gemäß einem bevorzugten Verfahren zum gegenseitigen Kontaktieren der beiden auf gegenüberliegenden Oberflächen des Substrats angeordneten, elektrisch leitfähigen Strukturen wird zunächst auf einer ersten Oberfläche eines flexiblen Substrats eine erste elektrisch leitfähige Struktur aufgebracht. Anschließend wird das flexible Substrat in einem Bereich der ersten elektrisch leitfähigen Struktur linienförmig durchtrennt, beispielsweise mittels eines Schnittwerkzeugs, Schneidstempels, Messers, Lasers oder ähnlichem. Diese linienförmige Durchtrennung erfolgt in einer Richtung schräg zur Oberfläche derart, dass die durch die Durchtrennungslinie voneinander getrennten Bereiche des flexiblen Substrats hintereinander verrasten können, wenn sie aneinander vorbeibewegt werden. Erst nach dem Schritt des Verrastens wird dann eine zweite elektrisch leitfähige Struktur auf der gegenüberliegenden Oberfläche des flexiblen Substrats so aufgebracht, dass sie mit der ersten elektrisch leitfähigen Struktur im Bereich der Verrastung so in Kontakt kommt, dass eine durch das Substrat hindurchführende elektrisch leitende Verbindung entsteht.

Im Gegensatz zum Stand der Technik werden die Arbeitsschritte umgestellt. Anstatt zuerst die Vorderseite und die Rückseite mit elektrisch leitfähigen Strukturen zu versehen und diese Strukturen dann im Wege der Durchkontaktierung elektrisch miteinander zu verbinden, wird nun vorgeschlagen, zunächst eine elektrisch leitfähige Struktur nur auf einer Oberfläche des Substrats aufzubringen, bereits danach den eigentlichen Durchkontaktierungsschritt durchzuführen, nämlich das aneinander Vorbeibewegen der an die Durchtrennungslinie angrenzenden Bereiche des flexiblen Substrats bis hin zur Verrastung, und erst danach die elektrisch leitfähige Struktur auf der gegenüberliegenden Oberfläche des Substrats herzustellen.

Dies bietet den Vorteil, dass das Material der zuletzt hergestellten elektrisch leitfähigen Struktur in die Durchtrennungslinie hineinfließen und mit der elektrisch leitfähigen Struktur auf der gegenüberliegenden Seite verbinden kann. Dieses Verfahren ist besonders zuverlässig, weil durch das aneinander Vorbeibewegen und hintereinander Verrasten an der Durchkontaktierungszone eine Vertiefung erzeugt wird, in die das Material zur Erzeugung der elektrisch leitfähigen Strukturen hineinfließen kann. Diese zuverlässige elektrische Verbindung wird bewirkt, ohne dass ein weiterer Prozessschritt, wie zum Beispiel ein Laminierschritt, erforderlich wäre, der die Verbindung stabilisiert. Sollte eine Überprüfung der elektrischen Verbindung im Einzelfall negativ ausfallen, so kann das Substrat ausgesondert werden, bevor es mit weiteren elektrischen Bauteilen bestückt wird.

Die Vertiefung, in die das Material der elektrisch leitfähigen Struktur hineinfließen soll, ist besonders ausgeprägt auf derjenigen Seite, von der aus der eine Bereich des Substrats hinter den anderen Bereich des Substrats gedrückt wird. Daher wird es bevorzugt, wenn die zuletzt aufgebrachte elektrisch leitfähige Struktur auf derjenigen Oberfläche aufgebracht wird, die beim Schritt des aneinander Vorbeibewegens der beiden Substratbereiche mit einer lokal begrenzten Druckkraft beaufschlagt wird, um diese Oberfläche hinter der anderen Oberfläche zu verrasten.

Weiter ist es vorteilhaft, wenn die linienförmige Durchtrennung nicht geradlinig ist, sondern wenn dadurch zumindest eine Lasche, vorzugsweise zwei einander gegenüberliegende Laschen, erzeugt werden. Die Form der sich ausbildenden Vertiefung lässt sich auf diese Weise geeignet beeinflussen. Als Material für das flexible Substrat kommt insbesondere Kunststoff in Betracht. Für die Herstellung von Chipkarten sind beispielsweise PVC-Folien als Substratmaterial gut geeignet. Die Erfindung ist aber nicht auf Substrate oder Leiterplatten für die Kartenfertigung beschränkt. Beispielsweise lässt sich die Erfindung auch auf Substrate anwenden, die aus Papier oder Pappe bestehen oder ein oder mehrere Papier- und/oder Pappschichten umfassen. Als Beispiel für Wertdokumente mit derartigen Substratmaterialien können Banknoten, Eintrittskarten, Fahrausweise und dergleichen genannt werden.

Besonders geeignet für die Herstellung der elektrisch leitfähigen Strukturen, insbesondere für die zuletzt aufgebrachte elektrisch leitfähige Struktur, sind Silberleitpasten. Die Silberleitpasten können vorteilhaft im Siebdruckverfahren aufgebracht werden. Sie sind ausreichend flüssig, um in die vorgenannte Vertiefung der Durchkontaktierung hinein zu fließen, mit der inzwischen getrockneten Silberleitplatte auf der gegenüberliegenden Oberfläche des Substrats in Kontakt zu kommen und in diesem Zustand zu trocknen, um so die zuverlässige elektrische Verbindung zwischen vorder- und rückseitiger leitfähiger Struktur herzustellen. Anstelle von Silberleitpasten eignen sich auch Karbonfarben als leitfähiges Material für die Durchkontaktierung im Siebdruckverfahren.

Alternativ kann auch elektrisch leitfähige Tinte eingesetzt werden. Elektrisch leitfähige Tinte hat ein besonders gutes Fließverhalten. Sie kann vorteilhaft mittels Tintenstrahldrucktechnik aufgebracht werden.

Die elektrisch leitfähigen Strukturen auf der Vorder- und Rückseite des Substrats bilden vorteilhaft eine zweiteilige Spule für die kontaktlose Daten-und/ oder Energieübertragung, wobei eine Spulenhälfte durch die elektrisch leitfähige Struktur auf einer Seite des Substrats und eine andere Spulenhälfte durch die elektrisch leitfähige Struktur auf der entsprechend gegenüberliegenden Seite des Substrats gebildet werden.

Die Trocknung der auf die Substratoberfläche aufgebrachten leitfähigen Strukturen kann anschließend in einem Trockentunnel erfolgen.

Ein mittels des erfindungsgemäßen Verfahrens hergestelltes durchkontaktiertes Substrat bzw. Leiterplatte zeichnet sich dann dadurch aus, dass ein an die Durchkontaktierung angrenzender Teilbereich der Substratoberfläche durch eine Fläche gebildet wird, die ursprünglich im Inneren des Substrats lag, nämlich durch eine der beiden Trenn- bzw. Schnittflächen, die beim linienförmigen Durchtrennen des flexiblen Substrats entstanden sind und durch das aneinander Vorbeibewegen und anschließende Verrasten zu Tage treten. Dadurch dass die zuletzt erzeugte elektrisch leitende Struktur erst nach dem Verrastungsschritt auf die Substratoberfläche aufgebracht wird, erstreckt sie sich zumindest über einen Teil dieses ursprünglich im Inneren des Substrats befindlichen Teilbereichs der Substratoberfläche. Insoweit unterscheiden sich die mit dem erfindungsgemäßen Verfahren hergestellten Substrate von solchen, bei denen die leitfähigen Strukturen auf gegenüberliegenden Oberflächen des Substrats zeitlich vor dem Durchkontaktieren aufgebracht werden.

Dieses Substrat kann anschließend zu einem Wertdokument, insbesondere eine Chipkarte, weiterverarbeitet werden. Dazu werden zunächst weitere elektronische Bauelement an die elektrisch leitenden Strukturen auf der Vorder- und/ oder Rückseite angeschlossen, und danach kann das Substrat z.B. mit weiteren Schichten laminiert werden.

Nachfolgend wird die Erfindung beispielhaft anhand der begleitenden Zeichnungen beschrieben. Darin zeigen:
- Figur 1A: die Vorderseite eines durchkontaktierten Substrats,
- Figur 1B: die Rückseite des durchkontaktierten Substrats aus Figur 1A,
- Figur 2A bis 2E: verschiedene Stadien der Durchkontaktierung gemäß einem ersten Ausführungsbeispiel und
- Figuren 3A bis 3E: verschiedene Stadien der Durchkontaktierung gemäß einem zweiten Ausführungsbeispiel.

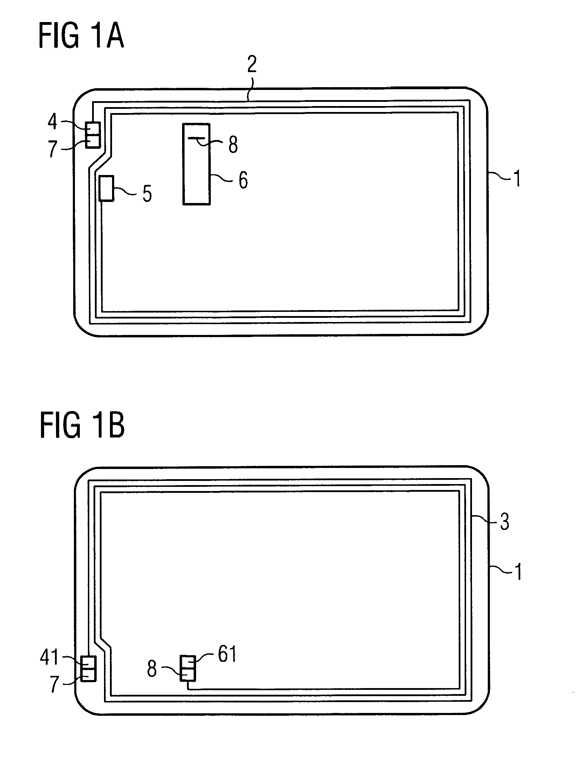

Figur 1A zeigt die Vorderseite eines Substrats 1, welches zum Einbau in einen Kartenkörper geeignet ist. Auf diese Seite des Substrats ist eine elektrisch leitfähige Struktur 2 in Form einer Spule für den kontaktlosen Daten-und Energieaustausch mit einem externen Gerät aufgebracht. Sie weist Kontaktzonen 4 und 5 auf, wobei die Kontaktzone 5 zur Kontaktierung mit einem IC-Modul vorgesehen ist. Eine weitere Kontaktierung der Spule mit dem IC-Modul erfolgt über die Kontaktzone 6, welche mittels einer Durchkontaktierung an der Stelle 8 mit der Kontaktzone 61 einer zweiten elektrisch leitfähigen Struktur 3 in Form einer zweiten Spule auf der Rückseite des Substrats 1 verbunden ist (Figur 1B). Eine weitere Durchkontaktierung derselben Art verbindet die Kontaktzone 4 der ersten Spule mit einer Kontaktzone 41 der zweiten Spule an der Stelle 7.

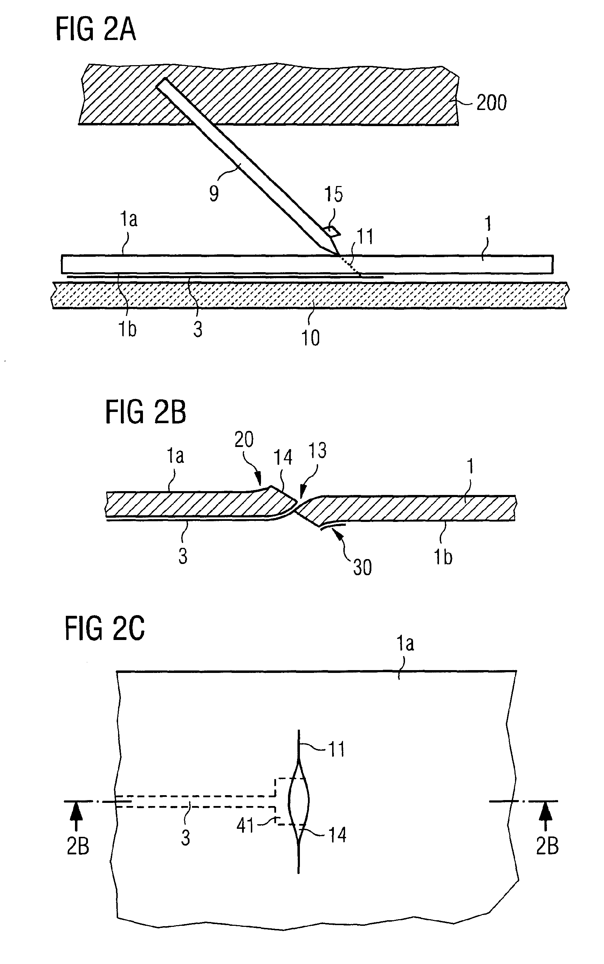

In den Figuren 2A bis 2E ist ein erstes Ausführungsbeispiel zur Durchführung der Durchkontaktierung dargestellt. Dabei liegt das Substrat 1 in einer Verarbeitungsstation auf einer weichen Unterlage 10, beispielsweise einer Gummimatte, auf. Bei unveränderter Position des Substrats 1 werden sowohl ein Schnitt 11 schräg zu den Oberflächen 1a, 1b des Substrats 1 erzeugt als auch die an den Schnitt 11 angrenzenden Bereiche 20, 30 des flexiblen Substrats 1 aneinander vorbeigedrückt, bis der Bereich 30 hinter dem anderen Bereich 20 einrastet, wie in Figur 2B im Schnitt dargestellt. Der Schnitt 11 im Substrat 1 wird vorzugsweise mit einem 45°-Winkel relativ zu den Substratoberflächen 1a, 1b erzeugt.

Der Schritt des aneinander Vorbeibewegens der beiden Bereiche 20, 30 erfolgt bei dem in Figur 2A dargestellten Ausführungsbeispiel mittels eines Mitnahmehakens 15 am Messer 9. Dazu wird das im Messerblock 200 verschieblich gelagerte Messer 9 zunächst in axialer Richtung vorgeschoben, um den Schnitt 11 zu erzeugen. Durch weiteres Voranschieben des Messers 9 kommt der Mitnahmehaken 15 in Kontakt mit dem in Figur 2A rechts vom Schnitt 11 liegenden Bereich 30 des Substrats 1 und drückt diesen Bereich zurück bis hinter den in Figur 2A links vom Schnitt 11 liegenden Bereich 20 des Substrats 1, so dass die beiden Bereiche hintereinander verrasten (Figur 2B).

Das Substrat 1 besitzt zum Zeitpunkt der Durchkontaktierung lediglich eine elektrisch leitfähige Struktur 3 auf der Substratrückseite 1b. Der Schnitt 11 erfolgt im Bereich dieser elektrisch leitfähigen Struktur 3 so, dass die Schnittfläche des Schnitts 11 und ein durchtrenntes Ende der elektrisch leitfähigen Struktur 3 an der Oberseite des Substrats 1 zu Tage treten. Die Schnittfläche bildet somit einen Teilbereich der Oberfläche 1a des Substrats 1 und begrenzt auf einer Seite eine Vertiefung 13, die durch das hintereinander Verrasten der beiden Bereiche 20 und 30 des Substrats 1 entstanden ist. Figur 2C zeigt diesen Verfahrenszustand in Draufsicht, während Figur 2B denselben Zustand im Querschnitt zeigt.

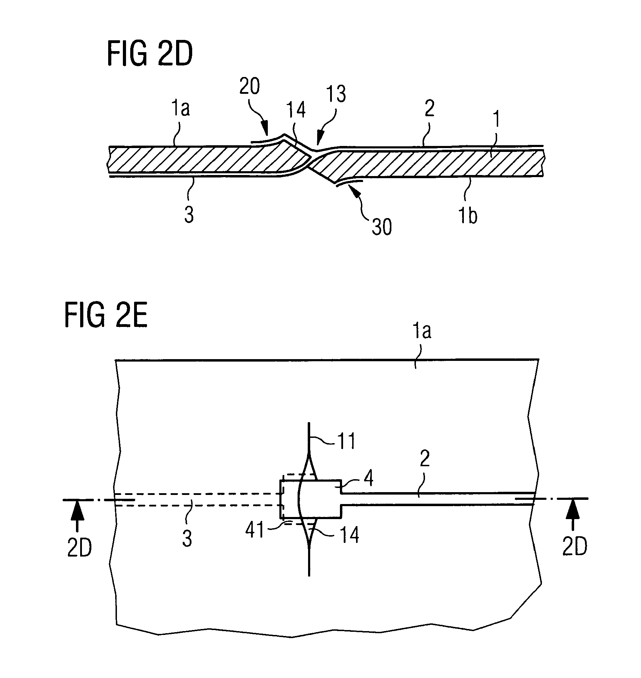

Als nächstes wird auf der Vorderseite des Substrats 1 eine weitere elektrisch leitende Struktur 2 auf die Oberfläche 1a aufgetragen, beispielsweise im Siebdruckverfahren mittels Silberleitpaste. Die Silberleitpaste fließt dabei in die Vertiefung 13 hinein und erstreckt sich dabei zumindest auch über einen Teil des Teilbereichs 14 der Oberfläche 1a. Es genügt dabei, wenn die elektrisch leitfähige Struktur 2 auf der Substratvorderseite an die Verrastung lediglich angrenzt, ohne sich darüber hinweg zu erstrecken, um so einen Kontakt mit der elektrisch leitfähigen Struktur 3 auf der Substratrückseite herzustellen. Die elektrisch leitende Struktur 2 kann sich aber auch vollständig über die Vertiefung 13 und den Teilbereich 14 hinweg auf den angrenzenden Bereich 20 des Substrats 1 erstrecken. Dies ist sogar zu bevorzugen, weil die Wahrscheinlichkeit einer mangelhaften Durchkontaktierung dadurch verringert wird, so wie dies in Figur 2D und 2E dargestellt ist.

Nachdem die Durchkontaktierung in der Bearbeitungsstation vollendet ist, kann das Substrat 1 der Bearbeitungsstation entnommen und beispielsweise in einem Laminierprozess mit weiteren Kunststoffschichten und gegebenenfalls mit weiteren elektronischen Bauelementen zu einer Kunststoffkarte fertiggestellt werden. Zuvor kann das Material der elektrisch leitenden Struktur 2 auf der Substratvorderseite getrocknet werden, beispielsweise in einem Trockentunnel.

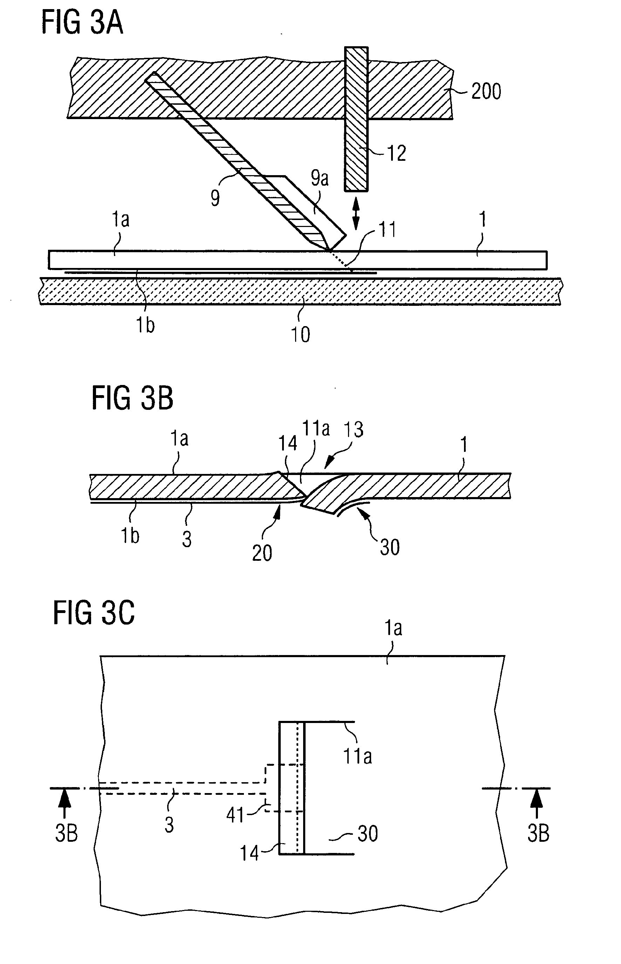

In den Figuren 3A bis 3E ist ein zweites Ausführungsbeispiel eines Durchkontaktierungsverfahrens dargestellt. Es unterscheidet sich von dem ersten Ausführungsbeispiel einerseits dadurch, dass die Durchtrennungslinie 11 nicht geradlinig sondern C-förmig verläuft, so dass der nach unten hindurch gedrückte Bereich 30 des Substrats 1 eine typische Laschenform besitzt, die aus der Ebene des Substrats 1 nach unten herausgebogen ist (Figur 3B). Zu diesem Zweck besitzt das Messer 9 seitliche Schneidelemente 9a, die dafür sorgen, dass beim Erzeugen des Schnitts 11 mittels der Schneidelemente 9a eine saubere Schnittfläche 11a rechtwinklig zu dem eigentlichen Schnitt 11 erzeugt wird. Der laschenförmige Bereich 30 ist dadurch an drei Seiten von dem Substrat 1 getrennt und nur noch an einer Seite mit dem Substrat 1 verbunden. Wie schon beim ersten Ausführungsbeispiel tritt auch bei diesem Ausführungsbeispiel die Schnittfläche des Schnitts 11 zu Tage, wenn der Bereich 30 hinter die rückseitige Oberfläche 1b des Substrats 1 verrastet, und bildet einen Teilbereich 14 der vorderseitigen Substratoberfläche 1a.

Anders als bei dem ersten Ausführungsbeispiel wird hier der Bereich 30 des Substrats 1 nicht mittels eines Mitnahmehakens hinter der rückseitigen Substratoberfläche 1b verrastet. Statt dessen wird dazu ein Stößel 12 eingesetzt, der in Pfeilrichtung auf und ab bewegbar ist. In diesem Falle wird zunächst der Schnitt 11 mittels des Messers 9 durch Voranschieben des Messers 9 in dessen Axialrichtung erzeugt und anschließend, bevor oder nachdem das Messer 9 in seine Ausgangsposition zurückbewegt wurde, wird mittels des Stößels 12 wiederum der rechts vom Schnitt 11 liegende laschenförmige Bereich 30 des Substrats 1 hinter den links vom Schnitt 11 liegenden Bereich 20 gedrückt. Der Stößel 12 besitzt einen vergleichsweise kleinen Querschnitt und drückt mit diesem Querschnitt lediglich den zentralen Bereich des laschenförmigen Bereichs 30 abwärts. Die Verwendung des Mitnahmehakens 15 und des Stößels 12 in den beiden beschriebenen Ausführungsbeispielen sind gegeneinander austauschbar oder auch kombinierbar. In beiden Fällen wird auf diese Weise eine lokal begrenzte Druckkraft auf die vorderseitige Oberfläche 1a derart ausgeübt, dass sie hinter der rückseitigen Oberfläche 1b verrastet.

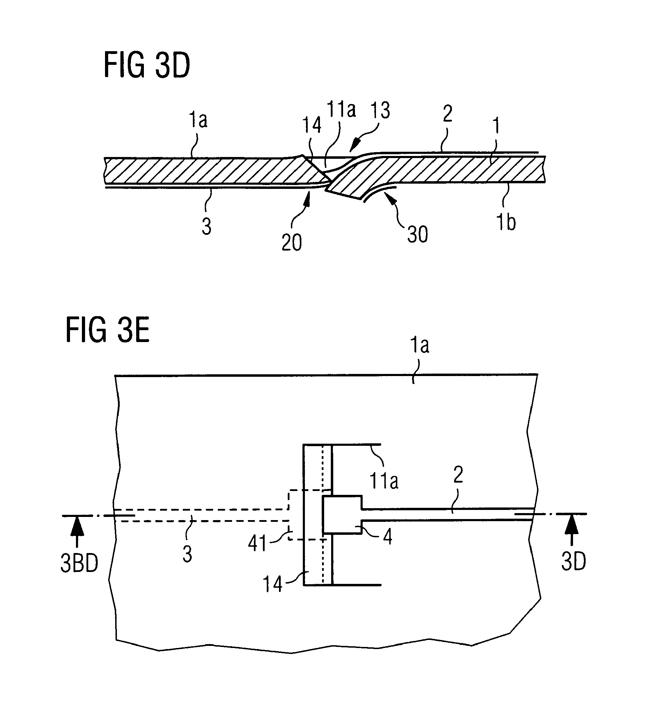

Während Figur 3B den Verfahrenszustand unmittelbar nach dem Verrasten in Querschnittsansicht zeigt, zeigt Figur 3C denselben Zustand in Draufsicht. Im nächsten Schritt wird wiederum die elektrisch leitende Struktur 2 auf die vorderseitige Oberfläche 1a des Substrats 1 aufgebracht, beispielsweise wiederum mittels Silberleitpaste im Siebdruckverfahren. Das Material der elektrisch leitenden Struktur 2 fließt dabei in die Vertiefung 13 hinein, gerät mit der ebenfalls bis in die Vertiefung 13 reichenden elektrisch leitfähigen Struktur 3 der rückseitigen Substratoberfläche 1b in Kontakt, trocknet aus und stellt so eine elektrisch leitfähige Verbindung zwischen den beiden Oberflächen 1a und 1b des Substrats 1 her. In Figur 3D ist dieser Zustand im Querschnitt, in Figur 3E in Draufsicht dargestellt.

## Patentansprüche

1. Verfahren zum gegenseitigen Kontaktieren von zwei auf einander gegenüberliegenden Oberflächen (1a, 1b) eines Substrats (1) angeordneten, elektrisch leitfähigen Strukturen (2, 3) durch das Substrat hindurch, umfassend die Schritte:
- Aufbringen einer ersten elektrisch leitfähigen Struktur (3) auf einer ersten Oberfläche (1b) eines flexiblen Substrats (1),
- linienförmiges Durchtrennen des flexiblen Substrats in einem Bereich der ersten elektrisch leitfähigen Struktur (3) in einer Richtung schräg zur ersten Oberfläche (1b),
- aneinander Vorbeibewegen von zwei an die Durchtrennungslinie (11) angrenzenden Bereichen (20, 30) des flexiblen Substrats, bis diese hintereinander verrasten, und
- Aufbringen einer zweiten elektrisch leitfähigen Struktur (2) auf einer der ersten Oberfläche (1b) gegenüberliegenden zweiten Oberfläche (1a) des flexiblen Substrats, **dadurch gekennzeichnet, dass** der Schritt des Aufbringens der zweiten elektrisch leitfähigen Struktur (2) nach dem Schritt des Verrastens derart erfolgt, dass die zweite elektrisch leitfähige Struktur (2) mit der ersten elektrisch leitfähigen Struktur (3) in Kontakt kommt und so eine durch das Substrat (1) hindurchführende elektrisch leitende Verbindung herstellt.

2. Verfahren nach Anspruch 1, **dadurch gekennzeichnet, dass** beim Schritt des aneinander Vorbeibewegens der zwei an die Durchtrennungslinie (11) angrenzenden Bereiche (20, 30) des flexiblen Substrats (1) eine lokal begrenzte Druckkraft auf die zweite Oberfläche (1a) ausgeübt wird, so dass die zweite Oberfläche (1a) hinter der ersten Oberfläche (1b) verrastet.

3. Verfahren nach Anspruch 1 oder 2, **dadurch gekennzeichnet, dass** durch den Schritt des linienförmigen Durchtrennens zumindest eine Lasche (30) in dem flexiblen Substrat (1) erzeugt wird, welche beim Schritt des aneinander Vorbeibewegens der zwei an die Durchtrennungslinie angrenzenden Bereiche (20, 30) aus dem flexiblen Substrat (1) herausgebogen wird.

4. Verfahren nach einem der Ansprüche 1 bis 3, **dadurch gekennzeichnet, dass** zumindest das Aufbringen der zweiten elektrisch leitfähigen Struktur (2) im Siebdruckverfahren erfolgt.

5. Verfahren nach einem der Ansprüche 1 bis 4, **dadurch gekennzeichnet, dass** zumindest die zweite elektrisch leitfähige Struktur (2) aus Silberleitpaste gebildet wird.

6. Substrat (1) mit einer ersten elektrisch leitfähigen Struktur (3) auf einer ersten Oberfläche (1b) des Substrats (1) und einer zweiten elektrisch leitfähigen Struktur (2) auf einer der ersten Oberfläche gegenüberliegenden zweiten Oberfläche (1a) des Substrats, wobei die erste elektrisch leitfähige Struktur und die zweite elektrisch leitfähige Struktur durch das Substrat hindurch miteinander kontaktiert sind und wobei ein Teilbereich (14) der zweiten Oberfläche (1a) durch eine Fläche gebildet wird, die ursprünglich im Inneren des Substrats (1) lag, **dadurch gekennzeichnet, dass** sich die zweite elektrisch leitfähige Struktur (2) zumindest über einen Teil dieses Teilbereichs (14) der zweiten Oberfläche (1a) erstreckt.

7. Substrat nach Anspruch 6, **dadurch gekennzeichnet, dass** zumindest die zweite elektrisch leitfähige Struktur (2) ein Siebdruck ist.

8. Substrat nach Anspruch 6 oder 7, **dadurch gekennzeichnet, dass** zumindest die zweite elektrisch leitfähige Struktur (2) getrocknete Silberleitpaste umfasst.

9. Wertdokument mit einem integrierten Schaltkreis, **gekennzeichnet durch** ein Substrat (1) nach einem der Ansprüche 6 bis 8.

10. Wertdokument nach Anspruch 9, **dadurch gekennzeichnet, dass** das Wertdokument eine Chipkarte ist.
